(19) Europäisches Patentamt
European Patent Office
Office européen des brevets

(11) **EP 4 120 361 A1**

(12) **EUROPEAN PATENT APPLICATION**

(43) Date of publication:
**18.01.2023 Bulletin 2023/03**

(21) Application number: **21186101.8**

(22) Date of filing: **16.07.2021**

(51) International Patent Classification (IPC):
**H01L 29/49** (2006.01)    **H01L 29/78** (2006.01)

(52) Cooperative Patent Classification (CPC):
**H01L 29/7802; H01L 29/4983; H01L 29/66734;**
**H01L 29/7395; H01L 29/7397; H01L 29/7813;**
H01L 29/0878; H01L 29/1095; H01L 29/42368;
H01L 29/42376; H01L 29/4916

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **Hitachi Energy Switzerland AG**
**5400 Baden (CH)**

(72) Inventors:
• **GUPTA, Gaurav**
  **5600 Aargau (CH)**
• **DE-MICHIELIS, Luca**
  **5000 Aarau (CH)**
• **VITALE, Wolfgang Amadeus**
  **5000 Aarau (CH)**

(74) Representative: **Epping - Hermann - Fischer**
**Patentanwaltsgesellschaft mbH**
**Schloßschmidstraße 5**
**80639 München (DE)**

(54) **POWER SEMICONDUCTOR DEVICE**

(57)    In at least one embodiment, the power semiconductor device (1) comprises:
- a semiconductor body (2) having a source region (21) of a first conductivity type and a well region (22) of a second conductivity type different from the first conductivity type, and the well region (22) comprises a channel region (220) starting directly at the source region (21), and
- a gate insulator (4) directly between the semiconductor body (2) and a gate electrode (31),
wherein the gate electrode (4) has a non-uniform work function profile (6) along the channel region (220), such that a threshold voltage ($V_{th}$) is highest in a first section (61) remote from the source region (21).

FIG 2

**Description**

A power semiconductor device is provided.

Document US 10 468 407 B2 refers to a Fin Field Effect Transistor (FinFET) device structure with an uneven gate structure.

Document US 7 141 858 B2 refers to dual work function CMOS gate technology based on metal inter-diffusion.

Document US 6 653 698 B2 discusses the integration of dual work function metal gate CMOS devices.

Embodiments of the disclosure relate to a power semiconductor device that shows improved electrical behavior.

This is achieved, inter alia, by a power semiconductor device as defined in claim 1. Exemplary further developments constitute the subject-matter of the dependent claims.

In at least one embodiment, the power semiconductor device comprises:

- a semiconductor body having a source region of a first conductivity type and a well region of a second conductivity type different from the first conductivity type, and the well region comprises a channel region starting directly at the source region, and
- a gate insulator directly between the semiconductor body and a gate electrode,

wherein the gate electrode has a non-uniform work function profile along the channel region, such that a threshold voltage of the gate electrode is highest in a first section of the channel region remote from the source region.

Hence, the work function $\Phi_m$ of the gate electrode in the first section remote from the source region is largest for n-channel devices and smallest for p-channel devices. In the following, unless indicated otherwise, the work function $\Phi_m$ is described for n-channel devices, but vice versa holds true for p-channel devices.

The gate electrode is insulated from the semiconductor body by the gate insulator.

For example, the at least one source region is in direct contact with the assigned gate insulator and/or is directly at the assigned channel region. The first conductivity type is, for example, n-conductive and, thus, the at least one source region is n-doped.

The at least one well region and consequently the at least one channel region are of the second conductivity type different from the first conductivity type. The second conductivity type is, for example, p-conductive and, thus, the at least one channel region is p-doped. It is possible that a maximum doping concentration of the at least one well region and/or of the at least one channel region is less than a maximum doping concentration of the at least one source region.

According to at least one embodiment, the semiconductor body further comprises a drift region which may be of the first conductivity type, too. For example, the drift region is in direct contact with the gate insulator and/or is directly at the channel region. The drift region may be located between the channel region and a drain region or a collector region of the semiconductor body, for example, in a direction perpendicular to the top side of the semiconductor body. For example, the optional trench may terminate in the drift region.

As an option, the semiconductor body can comprise an enhancement layer. For example, the enhancement layer is located directly between the well region and the drift region and may have a higher maximum doping concentration than the drift region. The enhancement layer can also be of the first conductivity type.

According to at least one embodiment, the power semiconductor device is a metal-insulator-semiconductor field-effect transistor, MISFET, a metal-oxide-semiconductor field-effect transistor, MOSFET, or an insulated-gate bipolar transistor, IGBT or a reverse-conducting insulated-gate bipolar transistor, RC-IGBT.

According to at least one embodiment, the well region extends from the top side of the semiconductor body to the drift region. The channel region is part of the well region and may have the same doping concentration. During operation, the electrons flow in the channel region from the source region to the drift region along the gate insulator. The channel region has a thickness in a direction perpendicular to an interface between the gate insulator and the well region, for example, in a nanometer range, exemplarily 1 nm to 50 nm.

For example, the semiconductor body is of silicon, Si for short. However, the semiconductor body can alternatively be of a wide-bandgap semiconductor material like SiC, $Ga_2O_3$ or GaN.

The gate insulator is made of any insulating material, which may be an oxide. For example, the gate insulator may be of at least one of the following materials: $SiO_2$, $Si_3N_4$, $Al_2O_3$, $Y_2O_3$, $ZrO_2$, $HfO_2$, $La_2O_3$, $Ta_2O_5$, $TiO_2$. Hence, the gate insulator may also be referred to as gate oxide.

According to at least one embodiment, the power semiconductor device is a power device. For example, the power semiconductor device is configured for a maximum voltage of at least 0.2 kV or of at least 0.6 kV or of at least 1.2 kV.

The power semiconductor device is, for example, for a power module in a vehicle to convert direct current from a battery or a fuel cell to alternating current for an electric motor, for example, in hybrid vehicles or plug-in electric vehicles. Moreover, the power semiconductor device can be a fuse, for example, in a vehicle like a car.

For simplification, in the following only one channel region and assigned components are mentioned. If there is a plurality of channel regions and assigned components, the features described below may apply to only one, to a plurality or to all of the channel regions and assigned components.

According to at least one embodiment, a work function difference of the gate electrode along the channel region is at least 0.7 eV or is at least 1.0 eV or is at least 1.1 eV. This applies, for example, when the gate electrode is based on poly-silicon. If metals like Li, Zn, Hf for a low work function, or metals like Pt, Pd or Au for a high work function are also considered, the work function difference may be at least 1.3 eV or at least 1.4 eV. For example, the work function difference is at most 2.0 eV or at most 1.5 eV. Here and in the following, the term 'along the channel region' may refer to a direction of a current flow in the channel region in the intended use of the power semiconductor device.

According to at least one embodiment, the gate electrode comprises a first material in the first section and a second material in a second section next to the source region. The first material has a higher work function $\Phi_m$ than the second material for n-channel devices and vice versa for p-channel devices.

It is possible that the gate electrode consists of the first section and of the second section. Otherwise, there can be at least one additional section, like a middle section, located between the first section and the third section, seen along the channel region. If there is at least one additional section, there can be at least one additional material having a work function $\Phi_m$ that is different from the work functions of the first material and of the second material.

According to at least one embodiment, the first material is p-doped poly-silicon and the second material is n-doped poly-silicon. This applies, for example, for a channel region of the n-type.

According to at least one embodiment, a length of the first section is at least 5% or is at least 10% or is at least 15% of an overall length of the channel region along the gate insulator. Alternatively or additionally, said length is at most 40% or at most 30% or at most 25% of said overall length. The same may apply to the at least one additional section, if present.

According to at least one embodiment, the gate insulator has a non-uniform thickness profile along the channel region. For example, along the channel region, the gate insulator is thickest in the first section, and consequently may be thinnest in the second section.

According to at least one embodiment, the channel region has a non-uniform channel doping profile along the gate insulator. For example, a doping concentration $N_A$ in the channel region is largest in the first section and consequently may be smallest in the second section.

According to at least one embodiment, there is the non-uniform thickness profile as well as the non-uniform channel doping profile. Hence, the work function of the gate electrode as well as the thickness of the gate insulator and the doping concentration $N_A$ in the channel region may vary along the channel region.

According to at least one embodiment, the thickness of the gate insulator varies significantly along the channel region. This means, for example, that a minimum thickness of the gate insulator is at most 70% or is at most 50% of a maximum thickness of the gate insulator. In this respect, only the gate insulator along the channel region may be relevant. According to at least one embodiment, along the gate insulator, a minimum doping concentration of the channel region is at most 50% or is at most 20% or is at most 10% of a maximum doping concentration of the channel region.

According to at least one embodiment, at least one of the non-uniform thickness profile, the non-uniform channel doping profile and the non-uniform work function profile run in a continuous, step-less manner. Thus, the at least one respective profile may be represented by a differentiable function.

According to at least one embodiment, at least one of the non-uniform thickness profile, the non-uniform channel doping profile and the non-uniform work function profile run in a stepped manner. Hence, the at least one respective profile comprises one or a plurality of steps and may not be represented by a differentiable function.

It is possible that the stepped non-uniform thickness profile, the non-uniform channel doping profiles and/or the non-uniform work function profile is combined with the non-stepped non-uniform thickness profile, the non-uniform channel doping profiles and/or the non-uniform work function profile.

According to at least one embodiment, the non-uniform work function profile and at least one of the non-uniform thickness profile and the non-uniform channel doping profile run in the same manner as the non-uniform work function profile. For example, the at least one step in the non-uniform work function profile and the at least one step in at least one of the non-uniform thickness profile and the non-uniform channel doping profile are at a same position along the channel region.

According to at least one embodiment, the gate electrode is partially or completely arranged in at least one trench formed in the semiconductor body. The at least one trench and, thus, the assigned gate electrode extends through the well region into the drift region, for example, in a direction away from a top side of the semiconductor body. Consequently, the gate insulator is located partially or completely in the assigned trench, too. Hence, the power semiconductor device could be a trench-based device.

Otherwise, the gate electrode and the gate insulator are applied on the top side of the semiconductor body. Thus, the top side may be a planar face.

According to at least one embodiment, the gate insulator has a non-uniform gate dielectric constant profile along the channel region, such that a relative dielectric constant of the gate insulator is lowest in the first part of the channel region remote from the source region.

According to at least one embodiment, there is the non-uniform thickness profile as well as the non-uniform channel doping profile and/or the non-uniform gate electrode work function profile and/or the non-uniform gate dielectric constant profile. That is, the non-uniform gate insulator thickness profile can be combined with the non-uniform channel doping profile, the non-uniform gate electrode work function profile or the non-uniform gate dielectric constant profile, or with two of the non-uniform channel doping profile, the non-uniform gate electrode work function profile and the non-uniform gate dielectric constant profile, or with all three other non-uniform profiles.

According to at least one embodiment, the power semiconductor device is configured so that both a saturation current and a short-circuit current are decreased, for example, while a collector-emitter saturation voltage $V_{ce-sat}$, and consequently on-state losses, may remain unaffected. This may be true because of the non-uniform work function profile, optionally supported by at least one of the non-uniform thickness profile and the non-uniform channel doping profile, and compared with an analogously set-up reference semiconductor device but having a uniform gate electrode work function profile along a gate insulator.

A power semiconductor device is explained in greater detail below by way of exemplary embodiments with reference to the drawings. Elements which are the same in the individual figures are indicated with the same reference numerals. The relationships between the elements are not shown to scale, however, but rather individual elements may be shown exaggeratedly large to assist in understanding.

In the figures:

Figure 1  is a schematic sectional view of a reference semiconductor device,

Figure 2  is a schematic sectional view of an exemplary embodiment of a power semiconductor device described herein,

Figure 3    is a top view of the power semiconductor device of Figure 2,

Figures 4 to 7   are schematic representations of electric data of power semiconductor devices described herein and of a reference semiconductor device,

Figures 8 to 11   are schematic sectional views of exemplary embodiments of power semiconductor devices described herein,

Figures 12 and 13  are schematic representations of non-uniform doping profiles and of non-uniform work function profiles of power semiconductor devices described herein, and

Figures 14 to 16  are schematic sectional views of exemplary embodiments of power semiconductor devices described herein.

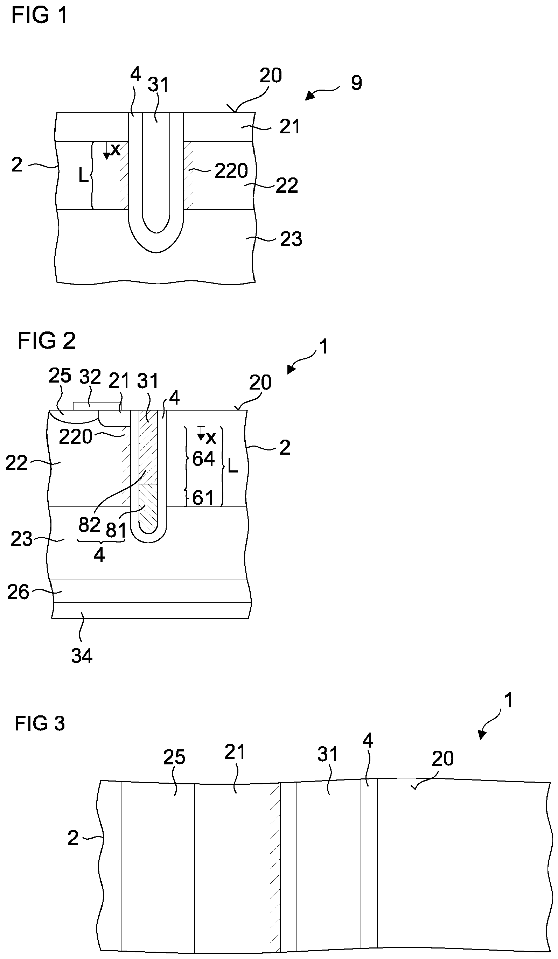

Figure 1 illustrates a reference semiconductor device 9 that corresponds to exemplary embodiments of power semiconductor devices 1 described herein except for a gate electrode work function profile in a channel region 220 included in a well region 22. Like the power semiconductor devices 1, the reference semiconductor device 9 comprises a semiconductor body 2 which is, for example, of Si.

The semiconductor body 2 also comprises a source region 21 at a top side 20 of the semiconductor body 2. A trench passes both through the well region 22 and through the source region 21. The source region 21 is of a first conductivity type, like n-conducting, and the well region 22, and consequently the channel region 220 included by the well region 22, is of a second, different conductivity type, like p-conducting. In the trench, there is a gate electrode 31 that is separated from the semiconductor body 2 by means of an electrically insulating gate insulator 4. The trench and, hence, the gate electrode 31 end in a drift region 23 of the semiconductor body 2. The drift region 23 is of the first conductivity type, too.

In the reference semiconductor device 9, the gate electrode 31 is of only one material that has a constant work function $\Phi_m$ all along the channel region 220, at areas of the gate electrode 31 facing the well region 22. That is, along a length direction x of the channel region 220 away from the source region 21 and towards the drift region 23, there is a uniform work function profile.

For example, next to the gate insulator 4 where the source region 21 and the channel region 220 are in direct contact, x = 0. For example, next to the gate insulator 4 where the channel region 220 and the drift region 23 are in direct contact, x = L. That is, L corresponds to a channel length of the channel region 220. It is noted that a shape of the channel region 220 is drawn only very schematically.

For example, x runs perpendicular to the top side 20 of the semiconductor layer body 2. Hence, the length L may correspond to a distance between the source region 21 and the drift region 23 directly at the gate insulator 4. Hence, the length L may be defined as the length of the second conductivity type layer between the layers of the first conductivity type, that is, the source region 21 and the drift region 23, wherein the drift region 23 may comprise an enhancement layer of higher doping concentration and a layer of lower doping concentration, not illustrated. x may be regarded as a current direction in the intended use of the reference semiconductor devices 9.

According to the exemplary embodiment of the power semiconductor device 1 as illustrated in Figures 2 and 3, the gate electrode 31 comprises a first material 81 and a second material 82. Along the length direction x, the first material 81 directly follows on the second material 82. Consequently, the gate electrode 31 has a non-uniform work function profile along the channel region 220.

A work function of the first material 81 is higher than a work function of the second material 82 because the semiconductor power device 1 described in Figures 2 and 3 is an n-channel device; correspondingly, for a p-channel device, the work function of the first material 81 would be lower than the work function of the second material 82. Thus, in a first section 61 remote from the source region 21, there is a maximum in the non-uniform work function profile. The rest of the channel region 220 is referred to as a second section 64. Within the first section 61 and also within the second section 64, respectively, the work function $\Phi_m$ is constant. Thus, along the channel region 220 the gate electrode 31 may consist of the second section 64 and of the first section 61 having the second material 82 and the first material 81, respectively. In a direction perpendicular to the length direction x, it is possible that the gate electrode 31 comprises only one material, that is, either the first material 81 or the second material 82.

For example, the first material 81 is $p^+$-doped poly-silicon having a work function of about 5.22 eV. For example, the second material 82 is $n^+$-doped poly-silicon having a work function of about 4.1 eV. Although based on silicon, these first materials 81 and second materials 82 can be referred to as metals.

As on option, to electrically contact the channel region 220, there can be at least one plug 25 at the top side 20 of the semiconductor body 2. The plug 25 may have a different thickness than the well region 22 so that the plug 25 can extend deeper or shallower into the semiconductor body 2 than the well region 22. Further, the thicknesses of the source region 21 and of the plug 25 can be the same or can be different.

Both the source region 21 and the at least one plug 25 may be electrically connected by means of the at least one source electrode 32 which is located at the top side 20, for example. Exemplarily, the plug 25 has a higher maximum doping concentration than the well region 22 or the channel region 220. The depth of the plug may be lower, deeper or the same as of the well region 22 and the channel region 220.

For example, the power semiconductor device 1 is an insulated-gate bipolar transistor, IGBT for short. Hence, at as side of the drift region 23 remote from the well region 22, there is a collector region 26 which is of the second conductivity type, too. At the collector region 26, there is a collector electrode 34. Additionally, there can be a buffer region of the first conductivity type between drift region 23 and the collector region 26. The doping concentration of the buffer region can be higher than that of the drift region 23. Seen in top view of the top side 20, the trench accommodating the gate electrode 31 and the gate insulator 4 may be of extended fashion. The source region 21, the at least one plug 25 as well as the channel region 220 may be arranged symmetrically on both sides of the trench, see Figure 3.

For example, maximum doping concentrations of the source regions 21, the collector region 26 or instead of a drain region 24 and the at least one plug 25 are at least $1 \times 10^{18}$ cm$^{-3}$ or at least $5 \times 10^{18}$ cm$^{-3}$ or at least $1 \times 10^{19}$ cm$^{-3}$ and/or at most $5 \times 10^{20}$ cm$^{-3}$ or at most $2 \times 10^{20}$ cm$^{-3}$ or at most $1 \times 10^{20}$ cm$^{-3}$. Further, a maximum doping concentration of the well region 22 and, thus, of the channel region 220 may be at least $5 \times 10^{16}$ cm$^{-3}$ or at least $1 \times 10^{17}$ cm$^{-3}$ and/or at most $5 \times 10^{19}$ cm$^{-3}$ or at most $5 \times 10^{18}$ cm$^{-3}$.

Depending on the voltage class of the power semiconductor device 1, a maximum doping concentration of the drift region 23 may be at least $1 \times 10^{11}$ cm$^{-3}$ or at least $1 \times 10^{12}$ cm$^{-3}$ or at least $1 \times 10^{13}$ cm$^{-3}$ and/or at most $1 \times 10^{17}$ cm$^{-3}$ or at most $5 \times 10^{16}$ cm$^{-3}$ or at most $1 \times 10^{16}$ cm$^{-3}$.

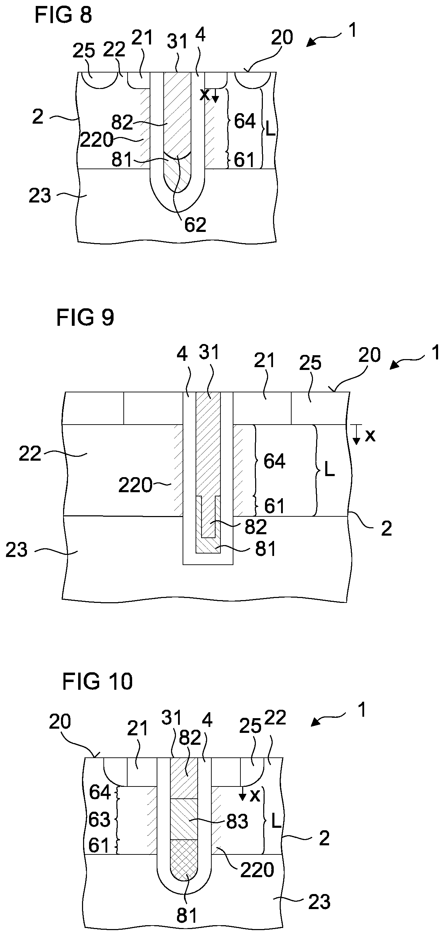

In Figures 2 and 3, the source region 21 and the at least one plug 25 are located along only one side of the gate electrode 31 so that there is a channel region 220 only along one outward side 42 of the gate insulator 4. However, the source region 21 as well as the at least one plug 25 can also be located along two sides of the gate electrode 31, compare, for example, Figure 9, or all around the gate electrode 31, when seen in top view.

Otherwise, the same as to Figure 1 may also apply to Figures 2 and 3.

The concept behind the gate electrode 31 having the non-uniform work function profile is explained in the following in some detail.

For a power semiconductor device 1, exemplarily for low frequency applications, it may be desirable to have on-state losses as low as possible in order to minimize the total electrical losses. Further, from a device reliability point of view, it may be advantageous to have a low short circuit current. Thus, a power semiconductor device 1 with minimized on-state losses and improved short circuit capability may be desired.

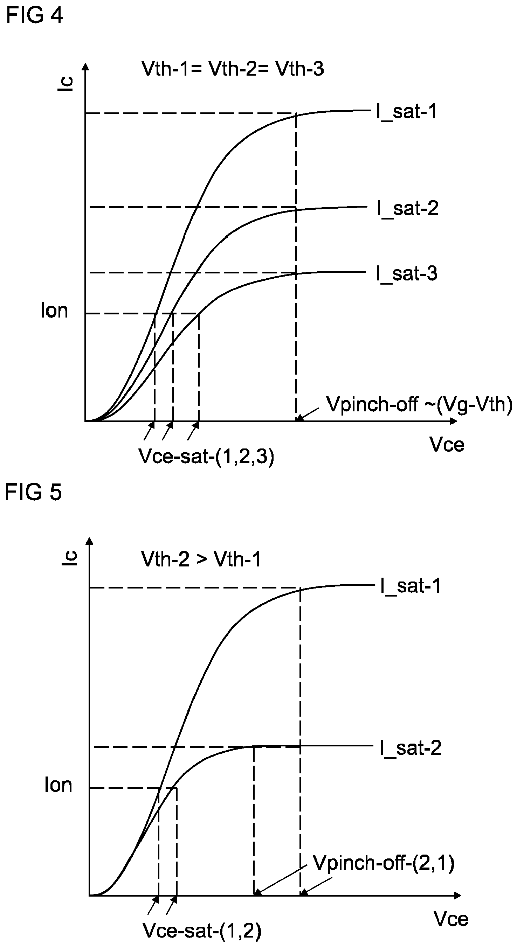

However, some means to lower an on-state voltage drop $V_{ce-sat}$, for example, by reducing the channel length L or increasing channel width W, often result in an undesired higher saturation current $I_{sat}$, as illustrated schematically using output characteristics $I_c$ vs. $V_{ce}$, see Figure 4. The higher $I_{sat}$ is directly related to a higher short circuit current $I_{sc}$, adversely affecting the short circuit capability of the power semiconductor device 1. On the other hand, raising a threshold voltage $V_{th}$ of the power semiconductor device 1 in order to lower $I_{sat}$, for example, by increasing a channel doping concentration, results in higher $V_{ce\text{-}sat}$ as illustrated in Figure 5. Thus, Figures 4 and 5 are schematics of typical output characteristics of an IGBT with a uniform threshold profile along the whole channel region, in Figure 4 for a same $V_{th}$ and different channel resistance, and in Figure 5 for different threshold voltages $V_{th}$.

Other techniques to reduce the short-circuit current such as:

a) increasing the channel length L,
b) reducing an anode injection efficiency, by reducing an anode implant dose,
c) reducing a channel width, by decreasing a source coverage along the trench, and
d) reducing the channel width, by increasing a cell pitch,

also undesirably result in higher on-state losses. Moreover, techniques such as d) can also adversely affect the breakdown capability of the power semiconductor device 1. Reducing gate biasing in order to reduce short-circuit current may also not be desirable as it leads to unstable dynamic behavior and moreover it is mainly defined by the application requirements.

Thus, there is a trade-off between minimizing the on-state losses and decreasing the short circuit current in a conventional MISFET or IGBT device. For an application requiring improved short circuit capability, it may be desirable to be able to decrease the short circuit current $I_{sc}$ without affecting $V_{ce\text{-}sat}$.

With the power semiconductor device 1 described herein, the trade-off between on-state losses and short circuit current is improved by improving the latter without adversely affecting the former. Differently from other approaches, the described design features a non-uniform threshold voltage profile along the channel region 220 next to the gate insulator 4 to lower down the saturation current for a given $V_{ce\text{-}sat}$.

The proposed non-uniform $V_{th}$ in the power semiconductor device 1 described herein is achieved by implementing the non-uniform work function profile 6 of the gate electrode 31 along the channel region 220. In addition, the described concept is applicable to any MOS device in general such as power-MOSFET or IGBT or reverse-conducting-IGBT and is even compatible with both planar and trench architectures.

With the power semiconductor device 1 described herein, an improved MISFET, MOSFET or IGBT device with an enhanced short circuit capability is introduced without a detrimental effect on the on-state losses. The improved design also relaxes the design constraints of the IGBT, enabling the possibility to independently explore the other methods mentioned above to minimize the on-state losses which are normally limited by the short circuit capability of the respective device.

In the following, some theoretical background to the idea of the semiconductor device 1 described herein is presented.

For a reference long channel MOS device, it is known that a channel pinch-off at high $V_{ce}$ is responsible for the current saturation in the output characteristics, which ultimately determines the short circuit current. The channel pinch-off voltage $V_{pinch\text{-}off}$ is determined by the threshold voltage $V_{th}$. Exemplarily, the channel starts pinching-off near its drain end, at x = L where L is the channel length, when the applied bias $V_{ce}$ exceeds the pinch-off voltage $V_{pinch\text{-}off}$ $\approx (V_g\text{-}V_{th})$, where $V_g$ is the applied gate voltage. At such applied $V_{ce}$, the voltage drop perpendicular to the channel is less than $V_{th}$ and therefore the channel cannot sustain any longer near the drain end.

However, for a more detailed understanding of the device, it should be considered that the channel pinch-off, however, is more of a local phenomenon, taking place specifically near the drain end of the channel. Therefore, more correctly, it is the local threshold voltage, $V_{th}(x)$, which determines the pinch-off point and, thus, the saturation current. This implies that it is possible to lower the $V_{pinch\text{-}off}$ by locally increasing $V_{th}(L)$ at the channel end, that is, in the first section 61 near the drift region 23.

Further, in order to keep the overall channel resistance and thereby $V_{ce\text{-}sat}$ unaffected, $V_{th}(x)$ can be decreased in the rest of the channel.

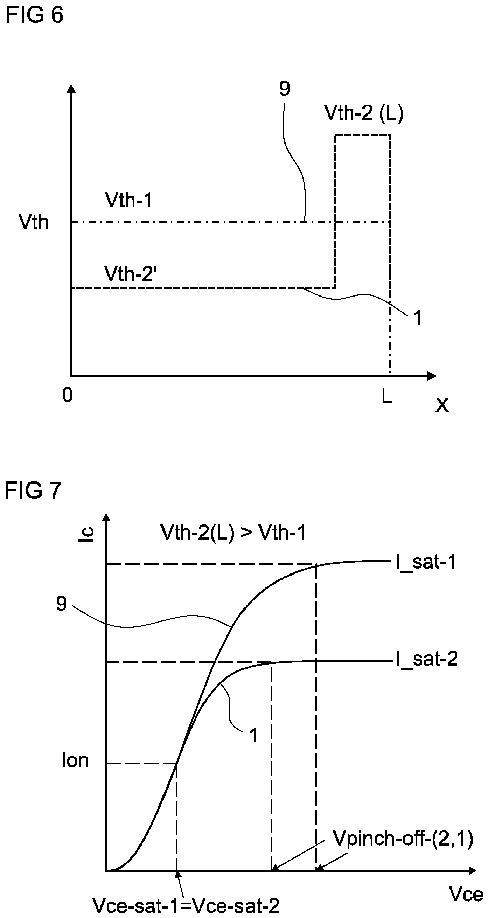

This is illustrated schematically in Figure 6 where the curve referring to the reference semiconductor device 9 comprises a uniform threshold voltage $V_{th\text{-}1}$ profile along the whole channel. The curve for the power semiconductor device 1 on the other hand consists of a non-uniform $V_{th}$ profile along the channel, where $V_{th}$ is locally raised near the channel end, that is, in the first section 61, such that $V_{th\text{-}2}(L) > V_{th\text{-}1}$ in order to lower the pinch-off point, while $V_{th\text{-}2}' < V_{th\text{-}1}$ in the rest of the channel to keep the overall channel resistance the same. In this way, a saturation current and thereby a short circuit current can be significantly reduced without affecting the on-state losses as illustrated in the schematic output in Figure 7. Local $V_{th}$ variation thus holds the key for improved short circuit capability of a MISFET or MOSFET or an IGBT device.

$V_{th}$ of the channel is a function of various other MOS cell design parameters as indicated in below equation:

$$V_{th} = V_{fb} + 2\Phi_B + \frac{\sqrt{qN_A 2\varepsilon_S 2\Phi_B}}{C_{ox}}$$

where $V_{th}$ is the threshold voltage, $V_{fb}$ is the flatband voltage, $V_{fb} = (\Phi_m - \Phi_s)$ where $\Phi_m$ and $\Phi_s$ are the gate electrode work function and the semiconductor work function, respectively. $N_A$ is the channel body doping, $\varepsilon_s$ is the permittivity of the semiconductor, $C_{ox}$ is the gate insulator capacitance, and $\phi_B$ is the semiconductor surface potential and:

$$\Phi_B = kt \ln \frac{N_A}{n_i}$$

where k is the Boltzmann constant, T is the temperature and $n_i$ is the intrinsic carrier concentration of the semiconductor.

Therefore, the required non-uniform Vth profile across the channel with relatively higher $V_{th}$ in the first section 61 can be achieved by introducing a non-uniformity in one or in any combination of the following MOS design parameters:

1. channel doping profile, $N_A(x)$, as detailed herein,
2. gate oxide thickness, Tox $(x)$,
3. gate dielectric, $\varepsilon_{ox}(y)$, and/or
4. gate metal work function, $\phi_m(x)$, since $V_{fb} = (\Phi_m - \Phi_s)$.

In the following, the focus is on the gate electrode work function profile variation, but said work function variation can of course be combined with a varying gate insulator thickness, a varying gate dielectric and/or a varying channel doping concentration.

It is noted that more than one combination of $\Phi_m(x)$ can achieve the same objectives. Moreover, even the physical length of higher and lower $\Phi_m(x)$ regions, that is, the length of the first section 61 along the length direction x, can be adjusted to suit the purpose and overcome the fabrication challenges.

Hence, non-uniformity in the $V_{th}$ profile along the channel region 220 can be achieved by introducing gate electrode materials with different work functions as illustrated schematically in Figure 2, for example. The work function $\Phi_m$ is related to $V_{th}$ via the flat band voltage $V_{fb} = (\Phi_m - \Phi_s)$, as indicated above. Therefore, any variation in $\Phi_m$ will directly results in a corresponding variation in the $V_{th}$.

According to Figure 8, there is a step in the non-uniform work function profile, too, like in Figure 2, but the first material 81 and the second material 82 do not have a plane interface perpendicular to the length direction x. Instead, the interface may have a spherical or meniscus-like shape. Hence, a transitional section 62 is formed.

Compared to the overall channel length L, a length of the transitional section 62 along the length direction x is small and amounts, for example, to at most 2% or to at most 5% of the overall channel length L. The same may apply to all other exemplary embodiments.

Accordingly, there is a step in the non-uniform work function profile at the interface between the first section 61 and the second section 64. However, said step does not need to exactly follow a theta function or unit step function, but there can be of sinusoidal shape because of the transitional section 62.

Such a transitional section 62, or a plurality of such transitional sections, could also be present in all other exemplary embodiments at the interface between the different materials of the gate electrode 31. For example, such at least one transitional section 62 may result from a manufacturing process of the gate electrode 31.

Moreover, according to Figure 8 at the top side 20 the well region 22 may extend between the plug 25 and the assigned source region 21. Seen in cross-section, the plug 25 and the assigned source region 21 may have different shapes and/or depths. These design features can be present individually or in combination also in all other exemplary embodiments.

Otherwise, the same as to Figures 2 to 7 may also apply to Figure 8, and vice versa.

In the power semiconductor device 1 of Figure 9, in the first section 61 there is the first material 81 as well as the second material 82. There, the first material 81 is located next to the gate insulator 4, and the second material 82 is remote from the gate insulator 4. Thus, perpendicular to the length direction x, there are both materials 81, 82. Because the second material 82 is limited to an interior of the gate electrode 31, the work function $\Phi_m$ at the channel region 220 is determined by the first material 81 only, for example. Hence, seen in cross section perpendicular to the top side 20, the first material 81 can be of U-shape in the first section 61. In the second section 64, there may be only the second material 82 having the lower work function $\Phi_m$. Accordingly, perpendicular to the length direction x and in the first section 220, the gate electrode 31 may be regarded as being of multi-layer fashion.

As it is possible in all other exemplary embodiments of the power semiconductor device 1, an outward side of the gate insulator 4 facing the semiconductor body 2 may be of planar fashion, at least along the channel region 220.

Moreover, in Figure 9 it is illustrated that the trench, in which the gate electrode 31 and the gate insulator 4 are located, does not necessarily have a curved bottom side facing the drain region 23. Hence, said bottom side may be planar and may be in parallel with the top side 20. The same is possible in all other exemplary embodiments.

Otherwise, the same as to Figures 2 to 8 may also apply to Figure 9, and vice versa.

According to Figure 10, the gate electrode 31 comprises a third material 83 which is located between the second material 82 and the first material 81, seen along the length direction x. For example, the work function $\Phi_m$ of the third material 83 exceeds the work function $\Phi_m$ of the second material 82, but is smaller than the work function $\Phi_m$ of the first material 81, in the case the power semiconductor device 1 is an n-channel device; if the power semiconductor device 1 would be a p-channel device, then the work function $\Phi_m$ of the third material 83 would be lower than the work function $\Phi_m$ of the second material 82, but higher than the work function $\Phi_m$ of the first material 81.

For example, all the materials 81, 82, 83 are based on poly-silicon with different doping. Otherwise, for example, the third material could be a metal having a high work function $\Phi_m$ like Pt.

Between the materials 81, 82, 83, there can be transitional sections, not shown, like in Figure 8. Further, in the middle section 63 and/or in the first section 61, the gate electrode 31 can be of multi-layer fashion, too, like in Figure 9.

Otherwise, the same as to Figures 2 to 9 may also apply to Figure 10, and vice versa.

Depending on the specific requirements, a $\Delta V_{th} = V_{th2} - V_{th1}$ may be desired that corresponds to a work function difference $\Delta \Phi_m$ of 2.5 eV to 3.0 eV. This may be difficult to achieve easily available practical work functions $\Phi_m$ which range from 4.1 eV for n$^+$-doped poly-silicon to about 5.22 eV for p$^+$-doped poly-silicon. Therefore, using available materials for the gate electrode 31, $\Delta V_{th} \approx 1$ V can be obtained which would result in some improved short circuit current vs. on-state trade-off as compared to single work function gate electrodes like in Figure 1. Moreover, different metals can also be explored as a gate electrode materials for obtaining higher work function contrast in order to achieve the required objectives.

For even better results, using the non-uniform work function profile can be combined with other proposed techniques for achieving a non-uniform $V_{th}$ profile such as non-uniform doping or non-uniform gate oxide thickness profiles. For example, the required $\Delta V_{th}$ can be achieved with the following combinations of gate insulator thickness variation, channel doping and gate metal work function in the first section 61 and in the second section 82 as illustrated in the following figures.

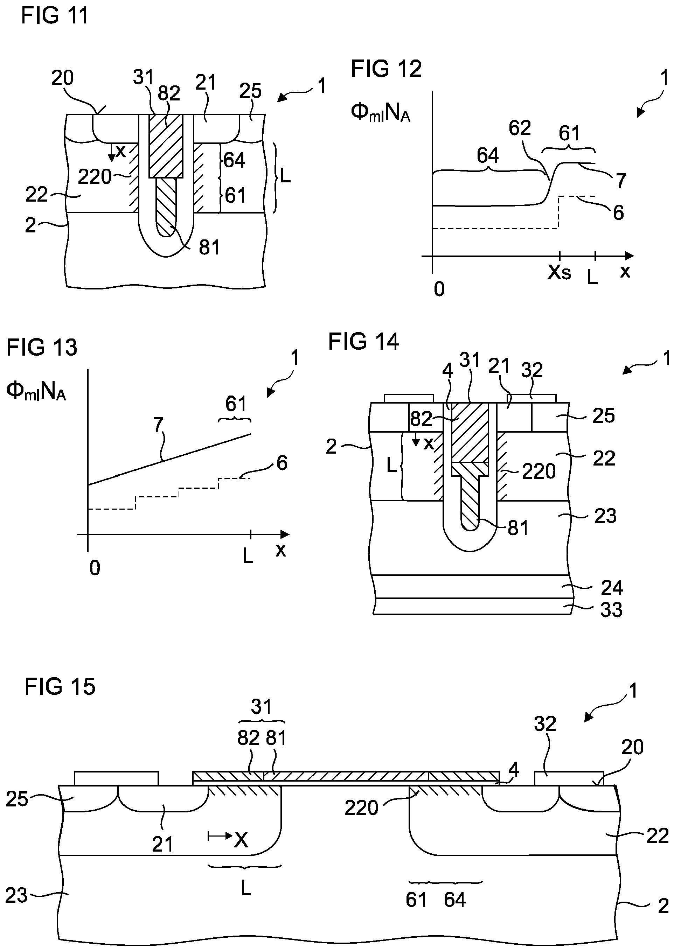

Thus, in Figure 11 it is illustrated that not only the work function profile is of non-uniform design, but also the thickness profile of the gate insulator 4. Thus, the gate insulator 4 is thickest in the first section 61 remote from the source region 21. Accordingly, the thickness of the gate insulator 4 may change in a stepped manner.

The non-uniform work function profile may also be stepped, wherein the materials 81, 82 of the gate electrode 31 can change at the same position along the length direction x as the thickness of the gate insulator 4. For example, the thickness of the gate insulator 4 may only change at the interface between the first material 81 and the second material 82.

Optionally, a thickness of the gate insulator 4 in the second section 64 is between 50 nm and 100 nm inclusive and/or a thickness of the gate insulator 4 in the first section 61 is between 100 nm and 240 nm inclusive.

For example, the work function of the second material 82 is 4.1 eV and the work function of the first material 82 is 5.22 eV. For achieving $\Delta V_{th} \approx 2.5$ to 3 V, the gate insulator 4 may have a thickness of 100 nm in the second section 64 and a thickness of 170 nm in the first section 61.

In Figure 11, the gate electrode 31 is configured analogously to Figure 2. However, in the power semiconductor device 1 of Figure 11 the gate electrode 31 may alternatively be design as depicted in any one of Figures 8 to 10 and 14.

Otherwise, the same as to Figures 2 to 10 may also apply to Figure 11, and vice versa.

In Figures 12 and 13, it is schematically illustrated that along the length direction x both the non-uniform work function profile 6 and a non-uniform channel doping profile 7 are applied. Thus, along the length direction x a doping concentration $N_A$ in the channel region 220 varies. As in the previous power semiconductor devices 1, here only the channel region 220 is of interest so that the doping concentration $N_A$ outside the channel region 220 is not discussed in Figures 12 and 13. Accordingly, the non-uniform work function profile 6 and the non-uniform thickness profile are also regarded only along the channel region 220, that is, for x = 0 to x = L.

According to Figure 12, both the work function profile 6 and the channel doping profile 7 are designed in a stepped manner wherein the step is in both profiles 6, 7 at $x = x_S$. However, for example, the step in the work function profile 6 may follow a theta function or unit step function, while in the channel doping profile 7 there may be the transitional section 62. Within the second section 64 and within the first section 61, respectively, the doping concentration $N_A$ may be constant.

For example, a maximum doping concentration present in the channel doping profile 7 is at least $5 \times 10^{16}$ cm$^{-3}$ and at most $3 \times 10^{18}$ cm$^{-3}$ and/or a minimum doping concentration present in the channel doping profile 7 is at most $2 \times 10^{17}$ cm$^{-3}$ or at most $1 \times 10^{17}$ cm$^{-3}$. The maximum doping concentration may be present in the first section 61, and the minimum doping concentration may be present in the second section 64.

As an example, the work function of the second material 82 is 4.1 eV and the work function of the first material 82 is 5.22 eV. For achieving $\Delta V_{th} \approx 2.5$ to 3 V, the doping concentration $N_A$ in the second section 64 is $1 \times 10^{17}$ cm$^{-3}$ and the doping concentration $N_A$ in the first section 61 is $2.8 \times 10^{17}$ cm$^{-3}$.

According to Figure 13, the channel doping profile 7 is of linear fashion. Hence, in the channel doping profile 7 there is no need for a well-defined interface or dividing line between the first section 61 and the second section 64. As an option, the work function profile 6 may have multiple steps so that a linear work function increase is approximated.

In the power semiconductor devices 1 of Figures 12 and 13, of course there can also be a non-uniform thickness profile of the gate insulator 4, like in Figure 11. For the thickness profile of the gate insulator 4 it is possible to be of linear fashion, too, like the channel doping profile 7 in Figure 13. Moreover, differently shaped non-uniform thickness profiles, non-uniform work function profiles and non-uniform channel doping profile can be combined with each other. Otherwise, the same as to Figures 2 to 11 may also apply to Figures 12 and 13, and vice versa.

In Figure 14 it is illustrated that there is the non-uniform thickness profile of the gate insulator 4 as well as the non-uniform work function profile, wherein both profiles are configured in a stepped manner. However, the steps in the profiles are at different positions along the length direction x. The same is possible in all other exemplary embodiments, too. As an option, not shown, there can also be the non-uniform channel doping profile in the channel region 220, for example, configured as shown in Figures 12 or 13.

Moreover, it is illustrated that the power semiconductor device 1 of Figure 14 is not an IGBT, but a MISFET or MOSFET. Consequently, the power semiconductor device 1 comprises a drain region 24 instead of the collector region 26. Hence, at as side of the drift region 23 remote from the well region 22, there is the drain region 24 which is of the first conductivity type, too, but, for example, with a maximum doping concentration higher than in the drift region 23. At the drain region 24, there is a drain electrode 33.

Of course, all the gate insulator designs of the IGBT power semiconductor devices 1 can apply for the MOSFET and MISFET power semiconductor device 1, and vice versa.

Otherwise, the same as to Figures 2 to 13 may also apply to Figure 14, and vice versa.

According to Figure 15, the power semiconductor device 1 is of a planar design and not of a trench design like, for example, the power semiconductor device 1 of Figures 2 and 3. Hence, the top side 20 is planar, and the gate insulator 4 and the gate electrode 31 are applied onto the top side 20. Consequently, the length direction x runs in parallel with the top side 20 from the source region 21 to the drift region 23, and not like in the other exemplary embodiments perpendicular to the top side 20.

In Figure 15, the well region 22 protrudes from the source region 21 in a lateral direction, that is, in parallel with the top side 20, and extends below the gate insulator 4. Also the source region 21 may extend below the gate insulator 4, but less far.

All the above-mentioned different designs of the non-uniform work function profile and of the optionally present non-uniform channel doping profile and/or non-uniform thickness profile can analogously be applied to the planar concept of Figure 15, both in case of a MISFET or MOSFET as well in case of an IGBT. Hence, the same as to Figures 2 to 13 can also apply to Figure 15.

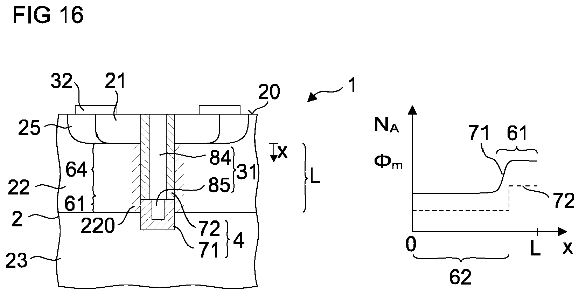

Moreover, in Figure 16 it is illustrated that there is not only the non-uniform gate electrode work function profile 6, but also a non-uniform gate insulator thickness profile and a non-uniform gate dielectric constant profile of the gate insulator 4 because of optionally present at least two different materials 71, 72, the gate insulator 4 is composed of. That is, the thickness of the gate insulator 4 varies along the channel region 220.

For example, a difference of the relative dielectric constant along the channel region 220 because of the at least two different materials 71, 72 is at least 2.0 or is at least 3.0 or is at least 3.5. Alternatively or additionally, said difference is at most 50 or is at most 25. When comparing the respective relative dielectric constants, text book values for the respective materials at room temperature, that is, 300 K, and at a frequency of a varying electric field of at most 1 kHz may be used.

For example, a thickness of the first material 71 in the first section 61 exceeds a thickness of the second material 72 in the second section 64, or vice versa. For example, a thickness difference between the first material 71 and the second material 72 is at least 20% or at least 40% of a maximum thickness of the gate insulator 4 along the channel region 220. If there is only the non-uniform gate insulator thickness profile and a uniform gate dielectric constant profile, the gate insulator 4 can be of a single material.

For example, a thickness of the gate insulator 4 in the second section 64 is between 50 nm and 100 nm inclusive and/or a thickness of the gate insulator 4 in the first section 61 is between 100 nm and 240 nm inclusive. However, other than illustrated in Figure 16, the thickness of the gate insulator 4 in the first section 61 can alternatively be smaller than in the second section 64, and a maximum thickness can instead be present in the second section 64.

Accordingly, there is a step in the non-uniform gate dielectric constant profile at the interface between the first section 61 and the second section 64, see the insert in Figure 16.

Additionally or alternatively to the non-uniform gate dielectric constant profile and/or the non-uniform gate electrode work function profile 72, there can be a non-uniform channel doping profile 71. That is, a doping concentration

$N_A$ in the well region 22 varies along the channel region 220.

For example, a maximum doping concentration present in the non-uniform channel doping profile 7 is at least $5 \times 10^{16}$ cm$^{-3}$ and at most $5 \times 10^{19}$ cm$^{-3}$ and/or a minimum doping concentration present in the non-uniform channel doping profile 71 is at most $2 \times 10^{17}$ cm$^{-3}$ or at most $1 \times 10^{17}$ cm$^{-3}$. The maximum doping concentration may be present in the first section 61, and the minimum doping concentration may be present in the second section 64. Throughout the first section 61 and the second section 64, respectively, the doping concentration $N_A$ may be constant so that the doping concentration $N_A$ varies in a stepped manner, for example. However, a step in the doping concentration $N_A$ does not need to exactly follow a theta function or unit step function, but there can be of sinusoidal shape, see the insert in Figure 16. Said step may be at the location where the materials 71, 72 of the gate insulator 4 change.

Such at least one of the non-uniform gate insulator thickness profile, the non-uniform gate insulator dielectric constant profile and the non-uniform channel doping profile 7 can be present analogously in all the other exemplary embodiments, too.

Otherwise, the same as to Figures 2 to 15 may also apply to Figure 16, and vice versa.

The components shown in the figures follow, unless indicated otherwise, exemplarily in the specified sequence directly one on top of the other. Components which are not in contact in the figures are exemplarily spaced apart from one another. If lines are drawn parallel to one another, the corresponding surfaces may be oriented in parallel with one another. Likewise, unless indicated otherwise, the positions of the drawn components relative to one another are correctly reproduced in the figures.

The power semiconductor device described here is not restricted by the description on the basis of the exemplary embodiments. Rather, the power semiconductor device encompasses any new feature and also any combination of features, which includes any combination of features in the patent claims, even if this feature or this combination itself is not explicitly specified in the patent claims or exemplary embodiments.

List of Reference Signs

1       power semiconductor device
2       semiconductor body
20      top side
21      source region
22      channel region
23      drift region
24      drain region
25      plug
26      collector region
31      gate electrode
32      source electrode
33      drain electrode
34      collector electrode
4       gate insulator
6       non-uniform work function profile
61      first section
62      transitional section
63      middle section
64      second section
7       non-uniform channel doping profile
71      first material of the gate insulator
72      second material of the gate insulator 81 first material
82      second material
83      third material
9       reference semiconductor device
L       length of the channel region along the gate insulator
x       length direction along the channel region

**Claims**

1.  A power semiconductor device (1) comprising:

    - a semiconductor body (2) having a source region (21) of a first conductivity type and a well region (22) of a second conductivity type different from the first conductivity type, and the well region (22) comprises a channel region (220) starting directly at the source region (21), and
- a gate insulator (4) directly between the semiconductor body (2) and a gate electrode (31),

wherein the gate electrode (31) has a non-uniform work function profile (6) along the channel region (220), such that a threshold voltage ($V_{th}$) is highest in a first section (61) of the channel region (220) remote from the source region (21).

2. The power semiconductor device (1) according to the preceding claim,
wherein a work function difference of the gate electrode (31) along the channel region (220) is at least 1.0 eV.

3. The power semiconductor device (1) according to any one of the preceding claims,
wherein the gate electrode (31) comprises a first material (81) in the first section (61) and a second material (82) in a second section (64) next to the source region (21), wherein the first material (81) has a higher work function $\Phi_m$ than the second material (82) if the channel region (220) is an n-type channel region, or the first material (81) has a lower work function $\Phi_m$ than the second material (82) if the channel region (22) is a p-type channel region.

4. The power semiconductor device (1) according to the preceding claim,
wherein the channel region (220) is of the n-type and the first material (81) is p-doped poly-silicon and the second material (82) is n-doped poly-silicon.

5. The power semiconductor device (1) according to any one of claims 3 and 4,
wherein, perpendicular to a length direction (x) of the channel region (220), the gate electrode (31) comprises either the first material (81) or the second material (82).

6. The power semiconductor device (1) according to any one of claims 3 and 4,
wherein, perpendicular to a length direction (x) of the channel region (220) and at least in the first section (61), the gate electrode (31) comprises the first material (81) and the second material (82).

7. The power semiconductor device (1) according to any one of the preceding claims,
wherein a length of the first section (61) is at least 10% and at most 40% of an overall length (L) of the channel region (220) along the gate insulator (4).

8. The power semiconductor device (1) according to any one of the preceding claims,
wherein at least one of the following is true:

- the gate insulator (4) has a non-uniform thickness profile along the channel region (220) so that, along the channel region (220), the gate insulator (4) is thickest in the first section (61), or
- the channel region (220) has a non-uniform channel doping profile along the gate insulator (4), so that a doping concentration $N_A$ in the channel region (220) is largest in the first section (61).

9. The power semiconductor device (1) according to the preceding claim,
wherein, along the channel region (220), a minimum thickness of the gate insulator (4) is at most 70% of a maximum thickness of the gate insulator (4).

10. The power semiconductor device (1) according to any one of claims 8 and 9,
wherein, along the gate insulator (4), a minimum doping concentration of the channel region (220) is at most 50% of a maximum doping concentration of the channel region (220).

11. The power semiconductor device (1) according to any one of claims 8 to 10,
wherein at least one of the non-uniform thickness profile and the non-uniform channel doping profile run in a continuous, step-less manner.

12. The power semiconductor device (1) according to any one of claims 8 to 11,
wherein the non-uniform work function profile (6) and at least one of the non-uniform thickness profile and the non-uniform channel doping profile have at least one step, wherein the step in the non-uniform work function profile (6) and the step in at least one of the non-uniform thickness profile and the non-uniform channel doping profile are located at a same position along the channel region (220).

13. The power semiconductor device (1) according to any one of the preceding claims,
wherein the gate electrode (31) is at least partially arranged in a trench formed in the semiconductor body (2) and through the well region (22).

14. The power semiconductor device (1) according to any one of claims 1 to 12,
wherein the gate electrode (31) and the gate insulator (4) are arranged on a planar top side (20) of the semiconductor body (2).

15. The power semiconductor device (1) according to any one of the preceding claims, wherein

- the source region (21) is in direct contact with the gate insulator (4) and the channel region (220),
- the semiconductor body (2) further comprises a drift region (23) which is of the first conductivity type and which is in direct contact with the gate insulator (4) and is located directly at the channel region (220), and
- the power semiconductor device (1) is a metal-insulator-semiconductor field-effect transistor, MISFET, a metal-oxide-semiconductor field-effect transistor, MOSFET, an insulated-gate bipolar transistor, IGBT, or a reverse-conducting insulated-gate bipolar transistor, RC-IGBT.

FIG 1

FIG 2

FIG 3

FIG 4

FIG 5

FIG 6

FIG 7

FIG 8

FIG 9

FIG 10

FIG 11

FIG 12

$\Phi_{ml} N_A$

FIG 13

$\Phi_{ml} N_A$

FIG 14

FIG 15

FIG 16

**EUROPEAN SEARCH REPORT**

Application Number

EP 21 18 6101

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/064550 A1 (SUGIMOTO MASAHIRO [JP] ET AL) 3 March 2016 (2016-03-03) | 1,7,8, 12-15 | INV. H01L29/49 |
| Y | * paragraph [0016] - paragraph [0035]; figure 1 * <br> * paragraph [0048] - paragraph [0075]; figures 4, 5, 6, 7 * | 2-6,9-11 | H01L29/78 |
| | ----- | | |
| X | US 2012/025874 A1 (SAIKAKU HIROTAKA [JP] ET AL) 2 February 2012 (2012-02-02) | 1,13,15 | |
| A | * paragraph [0120] - paragraph [0124]; figure 7 * <br> * paragraph [0127] - paragraph [0133]; figure 9 * <br> * paragraph [0195] - paragraph [0199]; figure 21 * <br> * paragraph [0268] * | 2-12,14 | |
| | ----- | | |
| Y | US 2015/214362 A1 (OH TAE-KYUNG [KR]) 30 July 2015 (2015-07-30) <br> * paragraph [0045] - paragraph [0046]; figure 2A * | 2-6 | |
| | ----- | | **TECHNICAL FIELDS SEARCHED (IPC)** |
| Y | EP 1 248 300 A2 (SCHINDENGEN ELECTRIC MFG CO LT [JP]) 9 October 2002 (2002-10-09) <br> * paragraph [0050]; figure 23 * <br> * paragraph [0069]; figure 50 * | 9,11 | H01L |
| | ----- | | |
| Y | US 2016/104794 A1 (TAKEUCHI YUICHI [JP] ET AL) 14 April 2016 (2016-04-14) <br> * paragraph [0028]; figure 1 * | 10 | |
| | ----- | | |

The present search report has been drawn up for all claims

| Place of search | Date of completion of the search | Examiner |
|---|---|---|
| Munich | 15 December 2021 | Lantier, Roberta |

EPO FORM 1503 03.82 (P04C01)

## ANNEX TO THE EUROPEAN SEARCH REPORT
## ON EUROPEAN PATENT APPLICATION NO.

EP 21 18 6101

This annex lists the patent family members relating to the patent documents cited in the above-mentioned European search report.
The members are as contained in the European Patent Office EDP file on
The European Patent Office is in no way liable for these particulars which are merely given for the purpose of information.

15-12-2021

| Patent document cited in search report | | Publication date | Patent family member(s) | | Publication date |
|---|---|---|---|---|---|
| US 2016064550 | A1 | 03-03-2016 | JP 2016054181 A | | 14-04-2016 |
| | | | US 2016064550 A1 | | 03-03-2016 |
| US 2012025874 | A1 | 02-02-2012 | CN 102347356 A | | 08-02-2012 |
| | | | DE 102011079747 A1 | | 02-02-2012 |
| | | | US 2012025874 A1 | | 02-02-2012 |
| | | | US 2015041850 A1 | | 12-02-2015 |
| US 2015214362 | A1 | 30-07-2015 | KR 20150090669 A | | 06-08-2015 |
| | | | US 2015214362 A1 | | 30-07-2015 |
| EP 1248300 | A2 | 09-10-2002 | EP 1248300 A2 | | 09-10-2002 |
| | | | JP 4073176 B2 | | 09-04-2008 |
| | | | JP 2002299619 A | | 11-10-2002 |
| | | | US 2002153558 A1 | | 24-10-2002 |
| | | | US 2005017294 A1 | | 27-01-2005 |
| US 2016104794 | A1 | 14-04-2016 | CN 105264667 A | | 20-01-2016 |
| | | | JP 6048317 B2 | | 21-12-2016 |
| | | | JP 2014236189 A | | 15-12-2014 |
| | | | US 2016104794 A1 | | 14-04-2016 |
| | | | WO 2014196164 A1 | | 11-12-2014 |

EPO FORM P0459

For more details about this annex : see Official Journal of the European Patent Office, No. 12/82

**REFERENCES CITED IN THE DESCRIPTION**

**Patent documents cited in the description**

- US 10468407 B2
- US 7141858 B2
- US 6653698 B2